(19)

Europäisches
Patentamt
European
Patent Office
Office européen
des brevets

(11) **EP 3 273 524 A1**

(12) **EUROPEAN PATENT APPLICATION**
published in accordance with Art. 153(4) EPC

(43) Date of publication:
**24.01.2018 Bulletin 2018/04**

(21) Application number: **15885407.5**

(22) Date of filing: **17.03.2015**

(51) Int Cl.:
*H01M 10/48* (2006.01)          *G01R 31/36* (2006.01)
*H02J 7/34* (2006.01)

(86) International application number:
**PCT/JP2015/057830**

(87) International publication number:
**WO 2016/147311 (22.09.2016 Gazette 2016/38)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicants:
• **Kabushiki Kaisha Toshiba
Minato-ku
Tokyo 105-8001 (JP)**
• **Toshiba Infrastructure Systems &
Solutions Corporation
Kawasaki-shi, Kanagawa 212-8585 (JP)**

(72) Inventors:
• **KIKUCHI, Yusuke**
**Tokyo 105-8001 (JP)**
• **KOSUGI, Shinichiro**
**Tokyo 105-8001 (JP)**
• **SEKINO, Masahiro**
**Tokyo 105-8001 (JP)**
• **KURODA, Kazuto**
**Tokyo 105-8001 (JP)**
• **OKABE, Ryo**
**Tokyo 105-8001 (JP)**

(74) Representative: **Awapatent AB
Junkersgatan 1
582 35 Linköping (SE)**

(54) **STORAGE-BATTERY MANAGEMENT DEVICE, METHOD, AND PROGRAM**

(57)      A storage battery management device according to an embodiment manages a plurality of storage battery systems of a plurality of channels in an electric power system, each of the storage battery systems having a storage battery device and a power adjustment device. A state of charge (SOC) estimation table stores a relationship between an open circuit voltage of the storage battery device and the SOC in advance. A measurement control unit sets a predetermined SOC area where the open circuit voltage and the SOC can be considered as a monotonic function by discharging or charging a storage batter device of SOC measurement target between a plurality of storage battery systems, and measures the open circuit voltage of the storage battery device of SOC measurement target by electrically disconnecting the storage battery device of SOC measurement target from a power supply/demand channel. As a result, an estimation unit estimates the SOC of the storage battery device by referring to the SOC estimation table based on the open circuit voltage measured in the SOC area. Therefore, even in a storage battery system in which charging and discharging are repeated at all times, it is possible to appropriately estimate an actual SOC and stably operate the storage battery system.

FIG.1

**Description**

FIELD

Embodiments of the present invention relate to a storage battery management device, a method, and a program

BACKGROUND

In recent years, safe and clean natural energy is introduced in power generation such as solar power generation or wind power generation. However, since output power of the natural energy is unstable, a voltage or a frequency of an electric power system may be adversely affected when a large number of power generation systems are employed. In addition, if a supply amount of such natural energy is remarkably larger than power demands, operation of the natural energy power generation system is interrupted inevitably. Therefore, a rate of the power generation utility is degraded.

In order to address such problems, it is expected to establish a large-scale storage battery provided with secondary batteries in parallel with the power generation systems in order to suppress a fluctuation in the output power of the natural energy using the charging/discharging power of the storage battery or store surplus power in the storage batteries.

CITATION LIST

Patent Literature

Patent Literature 1: US 6534954
Patent Literature 2: JP 5292375 B1
Patent Literature 3: JP 2013-183509 A
Patent Literature 4: JP 2013-195232 A
Patent Literature 5: JP 2014-119397 A

SUMMARY OF THE INVENTION

Problem to be Solved by the Invention

However, a storage battery system for an electric power grid is employed for the purposes of suppressing a fluctuation in the output power of natural energy, stabilizing a frequency of the electric power grid, and the like. In a case where the storage battery system is employed for these purposes, the storage batteries are repeatedly charged or discharged at all times, and there is no time to stop the system. As a method of estimating a state of charge (SOC) of the storage battery, a current integration method has been employed in the related art. However, in such a case where the charging and the discharging are repeated at all times, a current measurement error is accumulated. As a result, it is difficult to appropriately estimate the SOC and normally operate the storage battery system.

More specifically, in a case where the SOC estimation value is estimated to be smaller than the original value, a dischargeable capacity is reduced apparently, so that it is difficult to efficiently operate the storage battery system. In a case where the SOC estimation value is estimated to be larger than the original value, the storage battery reaches a discharge limitation voltage (Vlower) before the SOC becomes 0%, so that the storage battery system may be interrupted unexpectedly.

In view of the aforementioned problems, an object of the present invention is to provide a storage battery management device, a method, and a program capable of appropriately estimating an actual SOC and stably operating a storage battery system even when the storage battery system repeats charging and discharging at all times.

Means for Solving Problem

A storage battery management device manages a plurality of storage battery systems of a plurality of channels in an electric power system, each of the storage battery systems having a storage battery device and a power adjustment device.

a state of charge (SOC) estimation table stores in advance a relationship between an open circuit voltage of the storage battery device and the SOC.

a measurement control unit sets a predetermined SOC area where the open circuit voltage and the SOC can be considered as a monotonic function by discharging or charging a storage battery device of SOC measurement target between a plurality of storage battery systems, and measure the open circuit voltage of the storage battery device of SOC measurement target by electrically disconnecting the storage battery device of SOC measurement target from a power supply/demand channel.

Thereby, an estimation unit estimates the SOC of the storage battery device by referring to the SOC estimation table based on the open circuit voltage measured in the SOC area.

BRIEF DESCRIPTION OF DRAWINGS

FIG. 1 is a schematic diagram illustrating an electric power system provided with a plurality of storage battery systems.
FIG. 2 is a block diagram illustrating a schematic configuration of a storage battery system according to an embodiment.
FIG. 3 is an explanatory diagram illustrating specific configurations of a cell module, a CMU, and a BMU.
FIG. 4 is an explanatory diagram illustrating an SOC area suitable for measurement of an open circuit voltage.
FIG. 5 is a flowchart illustrating a process of measuring an open circuit voltage OCV according to an embodiment.
FIG. 6 is an explanatory diagram illustrating operations according to an embodiment.

DETAILED DESCRIPTION

Embodiments will now be described with reference to the accompanying drawings.

First Embodiment

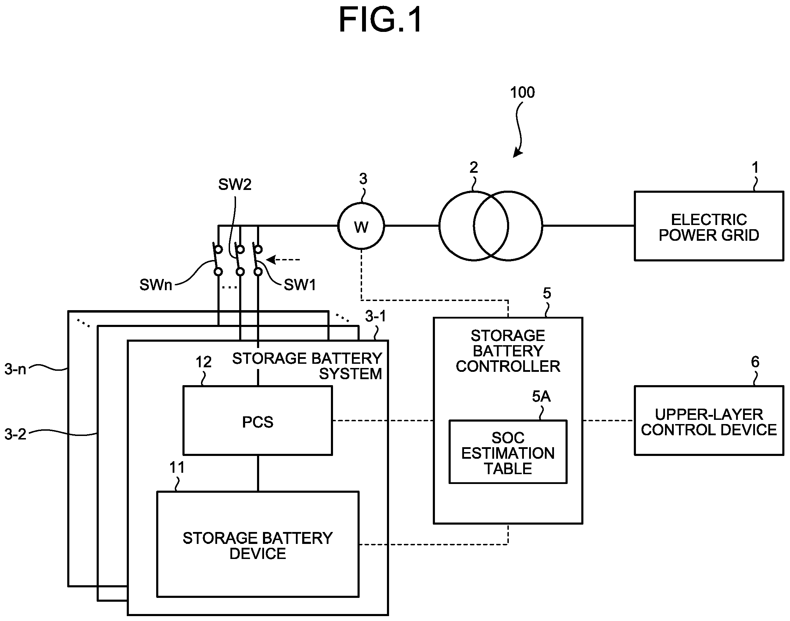

FIG. 1 is a schematic diagram illustrating an electric power system provided with a plurality of storage battery systems.
The electric power system 100 is connected to an electric power grid 1 through a transformer 2 and includes an electric power meter 2 configured to measure input or output power, a plurality of storage battery systems 3-1 to 3-n connected to the electric power grid 1 through switches SW1 to SWn and the electric power meter 2 to charge power from the electric power grid 1 or discharge and output power to the electric power grid, a storage battery controller 5 configured to locally control the storage battery systems 3-1 to 3-n and provided with an SOC estimation table 5A described below, and an upper-layer control device 6 configured to perform a remote control of the storage battery controller 5.
In the aforementioned configuration, the transformer 4 performs voltage transformation between the electric power grid 1 and the storage battery systems 3-1 to 3-n.

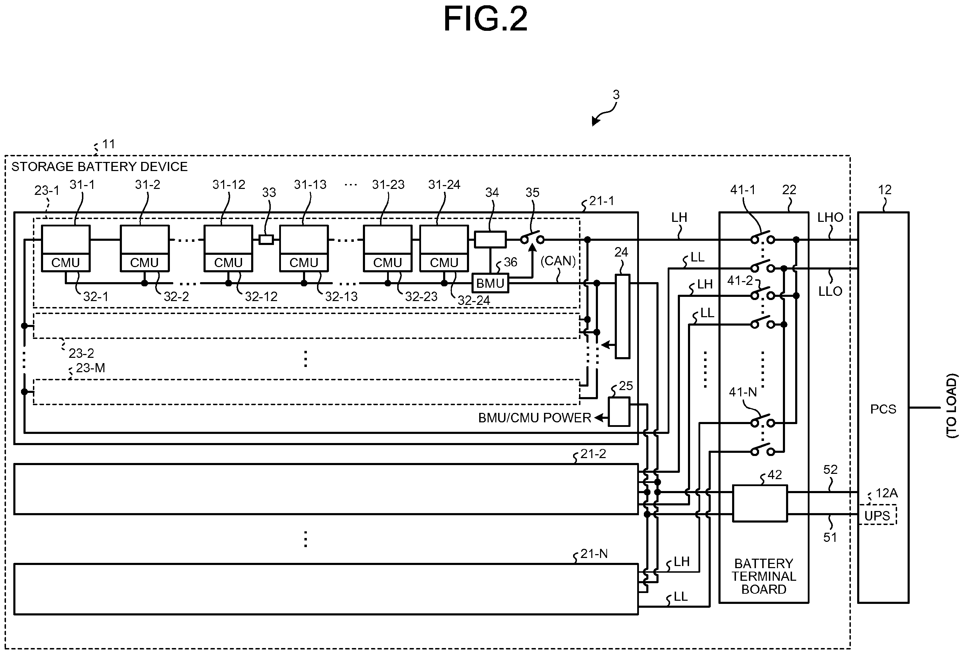

FIG. 2 is a schematic block diagram illustrating a storage battery system according to an embodiment.
Since the storage battery systems 3-1 to 3-n have the same configuration, the storage battery system 3-1 will be described representatively in the following description.
The storage battery system 3-1 generally includes a storage battery device 11 configured to store power and a power conditioning system (PCS) 12 configured to convert the DC power supplied from the storage battery device 11 into AC power having a desired quality of service and supply it to a load.
The storage battery device 11 generally includes a plurality of battery boards 21-1 to 21-N (where "N" denotes any natural number) and a battery terminal board 22 connected to the battery boards 21-1 to 21-N.
Each of the battery boards 21-1 to 21-N includes a plurality of electronic units 23-1 to 23-M connected in parallel with each other (where "M" denotes any natural number), a gateway unit 24, and a DC power unit 25 configured to supply the operational DC power to a battery management unit (BMU) and a cell monitoring unit (CMU) described below.
Here, a configuration of the electronic unit will be described.
The electronic units 23-1 to 23-M are connected to output power lines (bus lines) LHO and LLO through a high-voltage-side power supply line LH and a low-voltage-side power supply line LL, respectively, to supply power to the power conditioning system 12 serving as a main circuit.
Since the electronic units 23-1 to 23-M have the same configuration, the electronic unit 23-1 will be described representatively.
The electronic unit 23-1 generally includes a plurality of (twenty four in FIG. 2) cell modules 31-1 to 31-24, a plurality of (twenty four in FIG. 2) CMUs 32-1 to 32-24 provided in the cell modules 31-1 to 31-24, respectively, a service disconnector 33 provided between the cell modules 31-12 and 31-13, a current sensor 34, and a contactor 35. A plurality of cell modules 31-1 to 31-24, the service disconnector 33, the current sensor 34, and the contactor 35 are connected in series to each other.

Here, the cell modules 31-1 to 31-24 are connected to a plurality of battery cells in series and in parallel to constitute a battery pack. In addition, a plurality of cell modules 31-1 to 31-24 connected in series constitutes a group of battery packs.

In addition, the electronic unit 23-1 has a BMU 36, and the communication line of each of CMUs 32-1 to 32-24 and the output line of the current sensor 34 are connected to the BMU 36.

The BMU 36 controls the entire electronic unit 23-1 under the control of the gateway unit 24 to perform an open/close control of the contactor 35 on the basis of a result of communication with each of CMUs 32-1 to 32-24 (including voltage data and temperature data described below) and a detection result of the current sensor 34.

Next, a configuration of the battery terminal board 22 will be described.

The battery terminal board 22 includes a plurality of board disconnectors 41-1 to 41-N provided to mate with the battery boards 21-1 to 21-N and a master unit 42 which is a microcomputer configured to control the entire storage battery device 11.

The master unit 42 is connected to a control power line 51 used to supply power to the power conditioning system 12 through an uninterruptible power system (UPS) 12A of the power conditioning system 12 and a control communication line 52 used to exchange control data via the Ethernet (registered trademark) network.

Here, the cell modules 31-1 to 31-24, the CMUs 32-1 to 32-24, and the BMU 36 will be described in more details.

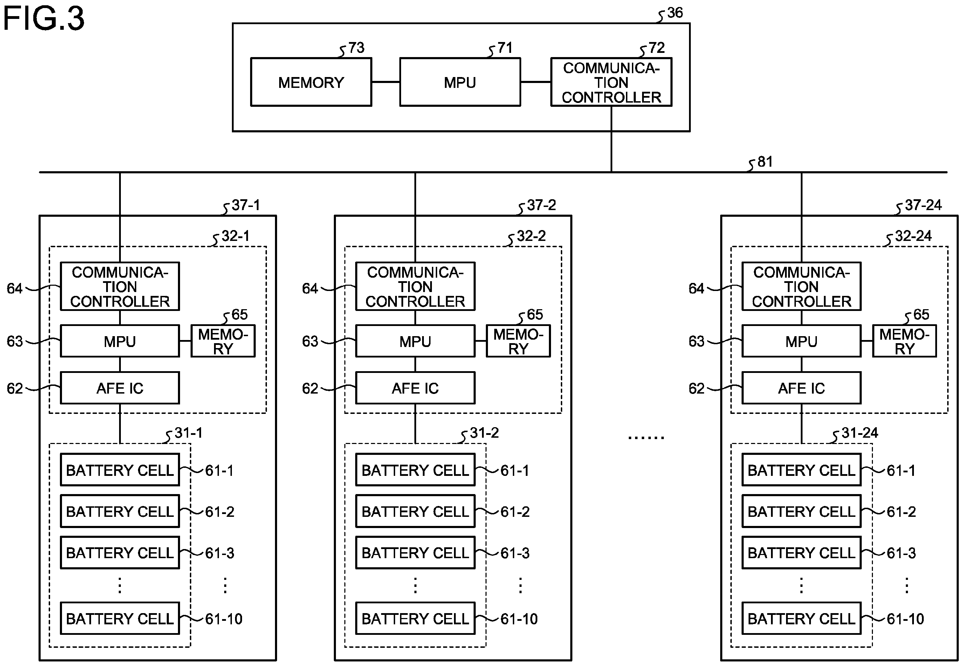

FIG. 3 is an explanatory diagram illustrating specific configurations of the cell module, the CMU, and the BMU.

Each of the cell modules 31-1 to 31-24 is provided with a plurality of (ten in FIG. 3) battery cells 61-1 to 61-10 connected in series.

Each of the CMUs 32-1 to 32-24 includes a voltage/temperature measurement IC (Analog Front End IC: AFE-IC) 62 for measuring voltages of the battery cells 61-1 to 61-10 of the corresponding one of the cell modules 31-1 to 31-24 and temperatures of predetermined portions, an MPU 63 configured to totally control the corresponding one of the CMUs 32-1 to 32-24, a communication controller 64 complying with the controller area network (CAN) standard for allowing the CAN communication with the BMU 36, and a memory 65 that stores the voltage data and the temperature data corresponding to the voltage of each cell.

In the following description, a combination of the corresponding cell modules 31-1 to 31-24 and the corresponding CMUs 32-1 to 32-24 will be referred to as battery modules 37-1 to 37-24. For example, a combination of the cell module 31-1 and the corresponding CMU 32-1 will be referred to as a battery module 37-1.

The BMU 36 includes an MPU 71 that totally controls the BMU 36, a communication controller 72 complying with the CAN standard for the CAN communication between the CMUs 32-1 to 32-24, and a memory 73 that stores the voltage data and the temperature data transmitted from the CMUs 32-1 to 32-24.

The storage battery controller 5 detects generated power of the natural energy power generation unit 1 and suppresses a fluctuation in the output of the generated power using the storage battery device 11 in order to alleviate influence on the electric power grid from this generated power. Here, a fluctuation suppression amount for the storage battery device 11 is calculated using the corresponding storage battery controller 5 or the upper-layer control device 6 and is issued to the power conditioning system (PCS) 12 corresponding to the storage battery device 11 as a charge/discharge command.

Next, an SOC measurement operation of the storage battery device 11 will be described.

In the following description, it is assumed that the SOC measurement (estimation) control of the storage battery device 11 is performed by the storage battery controller 5.

First, a measurement principle will be described.

In order to measure (estimate) the SOC of the storage battery device 11 with high accuracy, it is necessary to measure the open circuit voltage (OCV) in an equilibrium state by interrupting the charging and the discharging. However, for a storage battery system that performs charging and discharging at all times such as the storage battery systems 3-1 to 3-n according to this embodiment, it is difficult to use the method of measuring the open circuit voltage in an equilibrium state during a normal operation. Therefore, a method of estimating the SOC using current integration may be conceived. However, in this method, since errors are accumulated, it is indispensable to perform the SOC correction periodically.

Here, it is assumed that the current integration is performed by the BMU 36 on the basis of the output of the current sensor 34, and the storage battery controller 5 is notified of a result of the current integration.

In this regard, according to this embodiment, the storage battery controller 5 serves as a measurement control unit, so as to sequentially select one or a plurality of storage battery systems 3-x (where "x" = 1 to n) of the SOC measurement target out of a plurality of storage battery systems 3-1 to 3-n, and charge or discharge the selected storage battery system 3-x such that the SOC of the selected storage battery system 3-x is included in an SOC area suitable for measuring the open circuit voltage. Then, the storage battery controller 5 electrically disconnects the selected storage battery system 3-x from the charge/discharge path and waits until the storage battery device 11 included in the storage battery system 3-x has an equilibrium state. Then, the open circuit voltage OCV is measured. The storage battery controller 5 also serves as an estimation unit so as to estimate the SOC of the storage battery device 11 included in the storage battery system 3-x by referring to the SOC estimation table 5A stored in advance.

In this case, it is preferable that all of the selected storage battery systems serve as the SOC area suitable for measuring the open circuit voltage by selecting a plurality of storage battery systems and performing charging or discharging with each other.

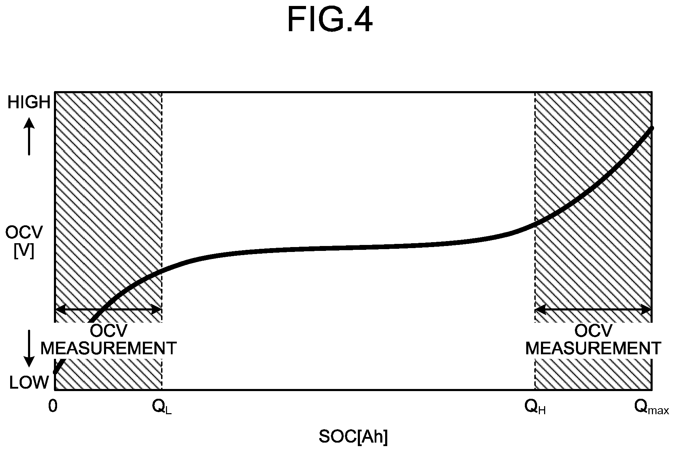

FIG. 4 is an explanatory diagram illustrating the SOC area suitable for measuring the open circuit voltage.

In FIG. 4, the unit of the SOC is set to "Ah". In addition, the discharge limitation of the storage battery device 11 is set to "Q = 0", and the full discharge state is set to "Q = $Q_{max}$".

As illustrated in FIG. 4, in both the low SOC area ($0 \leq SOC \leq Q_L$) and the high SOC area ($Q_H \leq SOC \leq Q_{max}$), the open circuit voltage OCV abruptly changes (slope is steep). Therefore, the selected storage battery system 3-x is charged or discharged such that the SOC belongs to one of these areas.

That is, the SOC area suitable for measuring the open circuit voltage is an area where the open circuit voltage OCV can be considered as a monotonic function (monotonically increasing function) by setting the SOC as a variable.

Next, operations according to the embodiment will be described.

In the following description, it is assumed that a current accessible amount of the entire electric grid is determined by an external request from the outside of the electric grid, a value ($I_{total}$) changes for each time $\Delta t$, and each PCS 12 performs charging and discharging in response to an instruction from the storage battery controller 5.

In addition, it is assumed that the current amount can be arbitrarily set by each PCS 12. In addition, the PCS 12 that performs charging for the storage battery device 11 and the PCS 12 that performs discharging from the storage battery device 11 may mixedly exist. As a result, the PCS that performs charging is supplied with power from the PCS that performs discharging.

In the following description, the time will be indicated by a discrete value tk.

That is,

$$t_{k+1} = t_k + \Delta t,$$

and

$$Q_j(t_k + 1) = Q_j(t_k) + I(t_k)\Delta t$$

For simplicity purposes, it is assumed that each PCS 12 has the same capacity. However, this embodiment can similarly apply to a case where the capacity is different.

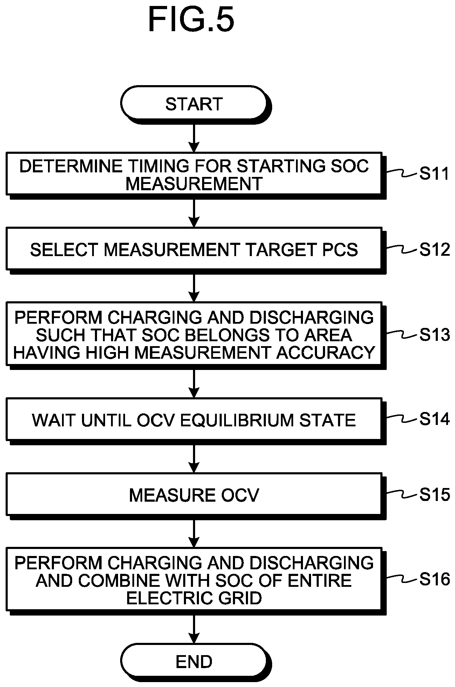

FIG. 5 is a flowchart illustrating a process of measuring the open circuit voltage OCV according to the embodiment.

First, the storage battery controller 5 determines an SOC measurement start timing (Step S11).

According to this embodiment, the SOC measurement start timing is determined using the following criteria.

(1) The measurement is performed within a predetermined time interval for any PCS 12 belonging to any one of the storage battery systems 3-1 to 3-n. In this case, this means that the interval may not be equal, and the measurement is performed once within a predetermined period. Here, in order to determine the predetermined period in advance, a period in which the accumulated error is within an allowable range is used as a reference in order to estimate the SOC on the basis of the current integration.

(2) In addition, the storage battery controller 5 sets an actual SOC measurement start timing as a time zone expected to have a low load.

This is because the PCS 12 of the measurement target is disconnected from the electrical grid and is excluded from a normal operation, so that a total capacity of the entire electric grid and a maximum charge/discharge current are reduced. Therefore, the storage battery controller 5 determines the timing such that there is no influence under such a situation.

That is, the SOC measurement start timing is set to a time zone in which a degraded operation is allowed.

Specifically, in the existing case, a low-load time zone based on applications of the electric grid includes late night, early morning, holiday, or the like. The SOC measurement time may be set to belong to such a period in the fixed scheduling.

In addition, the storage battery controller 5 may receive an instruction of the measurement start timing from the outside of the electric grid (for example, from the upper-layer control device 6).

In addition, the storage battery controller 5 may store a history of the past instructions regarding the charge/discharge amount, determine an expected low-load timing, and set this timing as the measurement start timing.

During the operation, the storage battery controller 5 may determine the measurement start timing by detecting that the SOC measurement accuracy becomes high.

That is, if the measurement starts in the vicinity of the discharge limitation or the full charge state, it is possible to reduce the subsequent charge/discharge time (in Step S13 described below).

Subsequently, the storage battery controller 5 selects the measurement target PCS 12 (Step S12).

In order to select the measurement target PCS 12, the following method may be employed.

(1) Each PCS is sequentially selected as the measurement target.

In this case, although it is not necessary to allocate a priority in particular, an easily measurable PCS may be suitably selected in the short term. Specifically, although the measurement for all the PCSs 12 are completed within a predetermined period described above, the order thereof may be changed as appropriate.

(2) In order to sequentially set each PCS as the measurement target, the following three cases may be possible.

(2.1) A pair of PCSs 12 is selected as the measurement target.

In this case, the power discharged from one of the PCSs 12 is used as power charged to the other PCS 12. As a result, a pair of PCSs 12 is selected so as to have the SOC range suitable for measurement at the same time through a single processing.

For this reason, it is necessary to make a sum of the SOCs of two PCSs (= $Q_1 + Q_2$) to satisfy the following constraint.

$$0 + Q_H \leq Q_1 + Q_2 \leq Q_L + Q_{max}$$

(2.2) "m" or more PCSs 12 are set as the measurement target (where "m" denotes any integer equal to or greater than "3").

In a case where an average SOC is biased toward the vicinity of the discharge limitation or the full charge state, it is conceived that the constraint for measuring the two PCSs 12 is not satisfied. Therefore, in this case, "m" or more PCSs 12 (where "m" denotes an integer equal to or greater than "3") are selected as the measurement target, and they are measured simultaneously.

In this case, it is necessary to satisfy the following constraint depending on a situation.

(2.2.1) If the average SOC is high, a single PCS 12 is discharged, and the remaining PCSs 12 are charged. In this case, the constraint is established as follows.

$$0 + (m - 1)Q_H \leq Q_1 + Q_2 + \ldots + Q_m \leq Q_L + (m - 1)Q_{max}$$

(2.2.2) If the average SOC is low, a single PCS 12 is charged, and the remaining PCSs 12 are discharged. In this case, the constraint is established as follows.

$$0 + Q_H \leq Q_1 + Q_2 + \ldots + Q_m \leq (m - 1)Q_L + Q_{max}$$

(2.3) A single PCS 12 is selected as the measurement target.

In this case, a total charge/discharge amount is set in response to an external instruction from the outside of the electrical grid. Therefore, in a case where a single measurement target PCS 12 is charged, the charging power is supplied from the discharging power of the other PCS 12.

In addition, in a case where a single measurement target PCS 12 is discharged, the discharging power is used as the charging power of the other PCS 12.

Subsequently, the storage battery controller 5 performs charging or discharging such that the SOC of the storage battery device 11 corresponding to the measurement target PCS 12 belongs to a high measurement accuracy area of the open circuit voltage OCV (Step S13).

In this case, if charging or discharging is performed between a pair of PCSs 12, one of the PCSs 12 is denoted by "PCS 12-1," and the other PCS 12 is denoted by "PCS 12-2" for simplicity purposes.

Assuming that the PCS 12-1 is in the discharging side, the PCS 12-2 is in the charging side, the current during the charging is expressed as a positive value, and the current during the discharging is expressed as a negative value, the following formulas are satisfied.

$$I_1(t_k) = -a,$$

and

$$I_2(t_k) = a,$$

where "$I_1(t_k)$" denotes a discharging current of the PCS 12-1, "$I_2(t_k)$" denotes a charging current of the PCS 12-2, and an absolute value of the charging/discharging current $|a|$ is constant.

$$\sum_{j=3}^{n} I_j(t_k) = I_{total}(t_k) \tag{1}$$

In addition, charging and discharging are performed until the following formula is satisfied.

$$Q_1 < Q_L \text{ and } Q_2 > Q_H$$

In a case where charging and discharging are performed between "m" or more PCSs 12 (PCS 12-1 to PCS 12-m) (where "m" denotes an integer equal to greater than "3"), assuming that the first PCS 12-1 is in the discharging side, the PCSs 12-2 to 12-m are in the charging side, "I1(tk)" denotes a discharging current of the PCS 12-1, "$I_2(t_k)$ to $I_m(t_k)$" denote the charging currents of the PCSs 12-2 to 12-m, and an absolute value of the charging/discharging current $|a|$ is constant, the following formulas are satisfied:

$$I_1(t_k) = -a,$$

$$I_x(t_k) = a/(m - 1) \text{ (where } x = 2, 3, \ldots, m),$$

and

$$\sum_{j=m+1}^{n} I_j(t_k) = I_{total}(t_k) \tag{2}$$

In addition, charging and discharging are performed until the following formulas are satisfied.

$$Q_1 < Q_L, \text{ and } Q_2 + \ldots + Q_m > Q_H$$

Alternatively, the first PCS 12-1 may be in the charging side, and the PCSs 12-2 to 12-m may be in the discharging side.
In a case where a single PCS is measured, assuming that the single PCS 12-1 is in the discharging side, all the remaining PCSs 12-2 to 12-n other than the measurement target are in the charging side, "$I_1(t_k)$" denotes a discharging current of the PCS 12-1, "$I_2(t_k)$ to $I_n(t_k)$" denote the charging currents of the PCSs 12-2 to 12-n, "Itotal(tk)" denotes the current requested from the outside of the electric grid, and an absolute value of the charging/discharging current $|a|$ is constant, the following formulas are satisfied:

$$I_1(t_k) = -a,$$

and

$$I_x(t_k) = (I_{total}(t_k) + a)/(n - 1) \text{ (where } x = 2, 3, \ldots, n).$$

In addition, charging and discharging are performed until the following formula is satisfied:

$$Q_1 < Q_L.$$

Subsequently, the storage battery controller 5 waits until the open circuit voltage OCV has an equilibrium state (Step S14).

In addition, after a time at which the open circuit voltage OCV has an equilibrium state elapses, the open circuit voltage OCV is measured (Step S15). In addition, the SOC is estimated on the basis of the OCV-SOC table prepared in advance by reflecting a relationship of FIG. 4.

Subsequently, the storage battery controller 5 performs charging or discharging for the storage battery device 11 using the measurement target PCS and combines the SOC of the storage battery device 11 with the SOC of the entire electric grid (Step S15).

In this case, in a case where the measurement is performed for a plurality of PCSs at the same time, first, charging and discharging are performed between the PCSs to equalize the SOC between the measurement target PCSs.

In addition, the SOC of the measurement target PCS 12 is equalized with the SOCs of other PCSs 12.

Specifically, in order to equalize the SOCs of all the PCSs after a time $b\Delta t$ elapses, the following formulas are preferably satisfied.

$$I_j(t_k) = \frac{\overline{Q}(t_k) - Q(t_k)}{b\Delta t} + \frac{I_{total}(t_k)}{n} \tag{3}$$

$$\overline{Q}(t_k) = \sum_j Q(t_k) / n$$

Although the above description is general, for the sake of easy understanding, charge/discharge between the two PCSs 12 (PCS 12-1 and PCS 12-2) in three storage battery systems 3-1 to 3-3 will be described as an example.

Here, it assumed that the first PCS 12-1 is charged, and the second PCS 12-2 is discharged. In addition, it is assumed that "QL = 20%," and "QH = 80%."

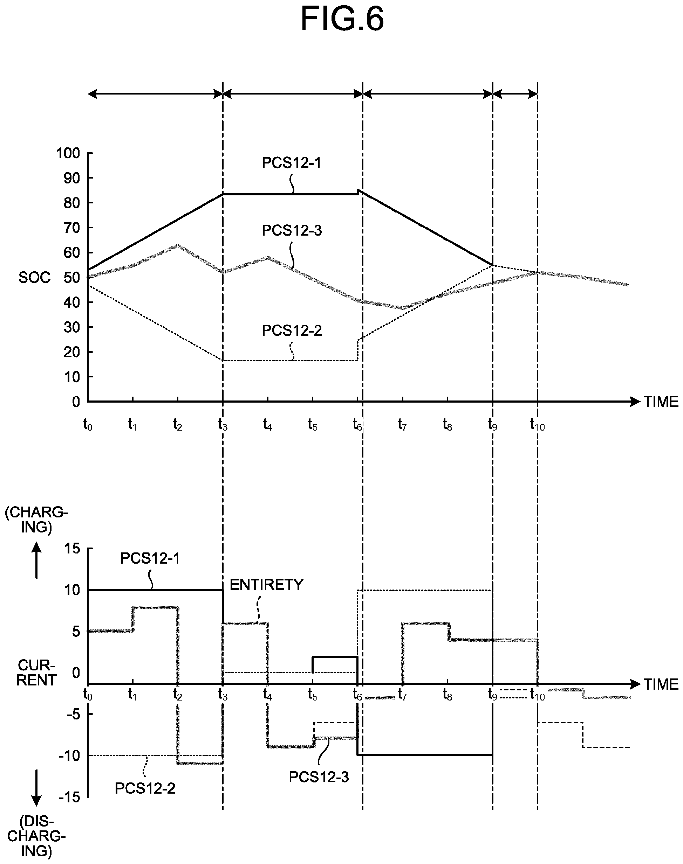

FIG. 6 is a diagram illustrating operations according to the embodiment.

First, the storage battery controller 5 determines the SOC measurement start timing as the timing t0 (Step S11) and selects the PCSs 12-1 and 12-2 of the measurement target (Step S12).

In FIG. 6, it is assumed that the PCSs 12-1 to 12-3 of the storage battery systems 3-1 to 3-3 of three channels have the SOC of approximately 50% in an initial state of the timing t0.

First, the storage battery controller 5 performs charging such that the SOC of the storage battery device 11 corresponding to the measurement target PCS 12-1 belongs to the area having high measurement accuracy for the open circuit voltage OCV (the SOC is equal to or higher than 80%). In addition, the storage battery controller 5 performs discharging such that the SOC of the storage battery device 11 corresponding to the measurement target PCS 12-2 belongs to the area having high measurement accuracy for the open circuit voltage OCV (the SOC is equal to or lower than 20%) (Step S13).

As a result, the discharging power of the storage battery device 11 corresponding to the measurement target PCS 12-2 becomes the charging power of the storage battery device 11 corresponding to the measurement target PCS 12-1.

In addition, at the timing t3, the SOC of the storage battery device 11 corresponding to the measurement target PCS 12-1 belongs to the area having the high measurement accuracy for the open circuit voltage OCV (the SOC is equal to or higher than 80%). In addition, the SOC of the storage battery device 11 corresponding to the measurement target PCS 12-2 belongs to the area having high measurement accuracy for the open circuit voltage OCV (the SOC is equal to or lower than 20%).

In this regard, for example, at the timings t3 to t5, the storage battery controller 5 waits until the open circuit voltage OCV has an equilibrium state (Step S14). For this reason, the storage battery controller 5 waits by setting the switches SW1 and SW2 in an open state.

In addition, until the timing t6 from the timing t5 at which it is estimated that the open circuit voltage OCV has an equilibrium state, the storage battery controller 5 measures the open circuit voltage OCV (Step S15).

Subsequently, at the timing t6, the storage battery controller 5 first closes (turns on) the switches SW1 and SW2 between the timings t6 to t9 to perform charging or discharging between the measurement target PCSs 12-1 and 12-2 to equalize the SOCs of the measurement target PCSs 12-1 and 12-2. In addition, at the timings t9 to t10, the SOCs of the PCSs 12-1 and 12-2 become equal to the SOC of the non-measurement target PCS 12-3, and the process is terminated (Step S16).

As described above, according to this embodiment, in order to estimate the SOC of the storage battery device included in the storage battery system, the measurement is performed by changing the SOC of the storage battery to the SOC area having high measurement accuracy for the open circuit voltage OCV serving as an estimation source. Therefore, even in a storage battery system in which charging and discharging are repeated at all times, it is possible to appropriately estimate the SOC of the storage battery device.

The storage battery management device (storage battery controller) according to this embodiment has a typical computer-based hardware configuration including a control device such as a CPU, a memory device such as a read-only memory (ROM) and a random access memory (RAM), an external storage device such as a hard disk drive (HDD) or a compact disc (CD) drive device, a display device as necessary, and an input device such as a keyboard or a mouse.

A program executed by the storage battery management device according to this embodiment is recorded on a computer readable recording medium such as a CD-ROM, a flexible disk (FD), a compact disc recordable (CD-R), and a digital versatile disk (DVD) in an installable format or an executable format.

The program executed by the storage battery management device according to this embodiment may be stored in a computer connected to a network such as the Internet and may be downloaded via the network. In addition, the program executed by the storage battery management device according to this embodiment may be provided or distributed via a network such as the Internet.

Furthermore, the program of the storage battery management device according to this embodiment may be embedded in a ROM or the like in advance to be provided.

The program executed by the storage battery management device according to this embodiment has a modular structure including each part described above (including the measurement control unit and the estimation unit). As an actual hardware configuration, a CPU (processor) reads the program from the storage medium and executes it by loading each part described above on a main storage device, so that the measurement control unit and the estimation unit are created on the main storage device.

While several embodiments of the invention have been described hereinbefore, such embodiments are just for illustrative purposes, and are not intended to limit the scope of the invention. These novel embodiments may be embodied in various other forms, and various omissions, substitutions, and changes may be possible without departing from the spirit and scope of the invention. Such embodiments and their modifications are construed as encompassing the scope or subject matter of the invention as attached in the claims and their equivalents.

**Claims**

1.  A storage battery management device that manages a plurality of storage battery systems of a plurality of channels in an electric power system, each of the storage battery systems having a storage battery device and a power adjustment device, the storage battery management device comprising:

    a state of charge (SOC) estimation table in which a relationship between an open circuit voltage of the storage battery device and the SOC is stored in advance;
    a measurement control unit configured to set a predetermined SOC area where the open circuit voltage and the SOC can be considered as a monotonic function by discharging or charging a storage battery device of SOC measurement target between a plurality of storage battery systems, and measure the open circuit voltage of the storage battery device of SOC measurement target by electrically disconnecting the storage battery device of SOC measurement target from a power supply/demand channel; and
    an estimation unit configured to estimate the SOC of the storage battery device by referring to the SOC estimation table based on the open circuit voltage measured in the SOC area.

2.  The storage battery management device according to claim 1, wherein the measurement control unit performs discharging or charging such that the SOCs of the plurality of storage battery devices are equalized after measurement of the open circuit voltage.

3.  The storage battery management device according to claim 2, wherein, assuming that the plurality of storage battery devices of the plurality of storage battery systems are divided into storage battery devices of SOC measurement target and storage battery devices of non-SOC measurement target, the measurement control unit performs discharging or charging such that the SOCs of all the storage battery devices are equalized after the SOCs of the storage battery devices of SOC measurement target are equalized in order to equalize the SOCs of the plurality of storage battery devices.

4. The storage battery management device according to claim 3, wherein, in a case where the storage battery devices of SOC measurement target are selected, the measurement control unit equalizes, out of the storage battery devices of SOC measurement target, the SOCs of the storage battery devices of SOC measurement target by discharging the storage battery devices belonging to the predetermined SOC area through the charging and charging the storage battery devices belonging to the predetermined SOC area through the discharging.

5. The storage battery management device according to claim 3, wherein, in a case where the storage battery devices of SOC measurement target are selected, the measurement control unit divides the storage battery devices of SOC measurement target into one storage battery device and the other storage battery devices, charges the one storage battery device, and discharges the other storage battery device, so as to set both the storage battery devices in the predetermined SOC area.

6. The storage battery management device according to any one of claims 1 to 5, wherein the measurement control unit measures the open circuit voltage if a predetermined time at which the open circuit voltage can be considered to have an equilibrium state elapses after the storage battery device is disconnected from the channel.

7. The storage battery management device according to any one of claims 1 to 6, wherein disconnection of the storage battery device of SOC measurement target from the power supply/demand channel is performed for a time period in which the electric power system can perform a degraded operation.

8. A method executed in a storage battery management device that manages a plurality of storage battery systems of a plurality of channels in an electric power system, each of the storage battery systems having a storage battery device and a power adjustment device, the storage battery management device having an SOC estimation table in which a relationship between an open circuit voltage of the storage battery device and the SOC is stored in advance, the method comprising:

setting a predetermined SOC area where the open circuit voltage and the SOC can be considered as a monotonic function by discharging or charging a storage battery device of SOC measurement target between a plurality of storage battery systems, and measuring the open circuit voltage of the storage battery device of SOC measurement target by electrically disconnecting the storage battery device of SOC measurement target from a power supply/demand channel; and
estimating the SOC of the storage battery device by referring to the SOC estimation table based on the open circuit voltage measured in the SOC area.

9. A computer program for controlling a storage battery management device that manages a plurality of storage battery systems of a plurality of channels in an electric power system, each of the storage battery systems having a storage battery device and a power adjustment device, the storage battery management device having an SOC estimation table in which a relationship between an open circuit voltage of the storage battery device and the SOC is stored in advance, the computer program causes the computer to function as:

a unit configured to set a predetermined SOC area where the open circuit voltage and the SOC can be considered as a monotonic function by discharging or charging a storage battery device of SOC measurement target between a plurality of storage battery systems, and measure the open circuit voltage of the storage battery device of SOC measurement target by electrically disconnecting the storage battery device of SOC measurement target from a power supply/demand channel; and
a unit configured to estimate the SOC of the storage battery device by referring to the SOC estimation table based on the open circuit voltage measured in the SOC area.

# FIG.1

# FIG.2

EP 3 273 524 A1

# FIG.3

EP 3 273 524 A1

# FIG.4

# FIG.5

START

DETERMINE TIMING FOR STARTING SOC MEASUREMENT — S11

SELECT MEASUREMENT TARGET PCS — S12

PERFORM CHARGING AND DISCHARGING SUCH THAT SOC BELONGS TO AREA HAVING HIGH MEASUREMENT ACCURACY — S13

WAIT UNTIL OCV EQUILIBRIUM STATE — S14

MEASURE OCV — S15

PERFORM CHARGING AND DISCHARGING AND COMBINE WITH SOC OF ENTIRE ELECTRIC GRID — S16

END

# FIG.6

## INTERNATIONAL SEARCH REPORT

| | International application No. |
|---|---|
| | PCT/JP2015/057830 |

**A. CLASSIFICATION OF SUBJECT MATTER**
*H01M10/48(2006.01)i, G01R31/36(2006.01)i, H02J7/34(2006.01)i*

According to International Patent Classification (IPC) or to both national classification and IPC

**B. FIELDS SEARCHED**

Minimum documentation searched (classification system followed by classification symbols)
H01M10/42-10/48, G01R31/36, H02J7/00-7/12, H02J7/34-7/36, H02J3/32, H02J3/38-3/50

Documentation searched other than minimum documentation to the extent that such documents are included in the fields searched
| Jitsuyo Shinan Koho | 1922–1996 | Jitsuyo Shinan Toroku Koho | 1996–2015 |
| Kokai Jitsuyo Shinan Koho | 1971–2015 | Toroku Jitsuyo Shinan Koho | 1994–2015 |

Electronic data base consulted during the international search (name of data base and, where practicable, search terms used)
JDreamIII, Scopus

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2012-205480 A (Mitsubishi Heavy Industries, Ltd.),<br>22 October 2012 (22.10.2012),<br>paragraphs [0005] to [0028]; fig. 1 to 3<br>(Family: none) | 1,2,6-9<br>3-5 |
| Y<br>A | WO 2013/190610 A1 (Hitachi, Ltd.),<br>27 December 2013 (27.12.2013),<br>paragraphs [0004] to [0031], [0061] to [0083],<br>[0092] to [0094], [0105] to [0119]; fig. 1 to 3,<br>6 to 9, 12<br>(Family: none) | 1,2,6-9<br>3-5 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 May 2015 (22.05.15) | 02 June 2015 (02.06.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | |
| | Telephone No. |

Form PCT/ISA/210 (second sheet) (July 2009)

**INTERNATIONAL SEARCH REPORT**

International application No.

PCT/JP2015/057830

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2014-110692 A (Sumitomo Electric Industries, Ltd.),<br>12 June 2014 (12.06.2014),<br>paragraphs [0015], [0017], [0027], [0028], [0039] to [0044], [0065] to [0067]; fig. 1, 8, 11<br>(Family: none) | 1,2,6-9<br>3-5 |
| Y | JP 2014-132243 A (Toshiba Corp.),<br>17 July 2014 (17.07.2014),<br>paragraphs [0022] to [0034]; fig. 1 to 4<br>(Family: none) | 6 |
| A | JP 2010-283922 A (Toyota Motor Corp.),<br>16 December 2010 (16.12.2010),<br>paragraphs [0008] to [0013], [0033], [0034], [0039] to [0042], [0060] to [0070], [0082] to [0141]; fig. 1 to 27<br>& US 2012/0065824 A1 & WO 2010/140044 A1<br>& EP 2438452 A1 & CA 2757943 A1<br>& CN 102803977 A | 1-9 |

Form PCT/ISA/210 (continuation of second sheet) (July 2009)

**EP 3 273 524 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6534954 B
- JP 5292375 B
- JP 2013183509 A
- JP 2013195232 A
- JP 2014119397 A